# EUROPÄISCHE PATENTSCHRIFT

(11) **EP 1 755 163 B1**
(45) Veröffentlichungstag und Bekanntmachung des Hinweises auf die Patenterteilung: **26.12.2007**
(21) Anmeldenummer: 06017116.2
(22) Anmeldetag: 17.08.2006
(51) Int. Cl.: H01L 25/07

(54) **Leistungshalbleitermodul mit Leitungssegment**
Power semiconductor module with wiring element
Module semiconducteur de puissance avec segment de ligne

(30) Priorität: 19.08.2005 DE 102005039278
(43) Veröffentlichungstag der Anmeldung: 21.02.2007
(73) Patentinhaber: SEMIKRON Elektronik GmbH & Co. KG, 90431 Nürnberg (DE)
(72) Erfinder: Stockmeier, Thomas Dr., 91054 Erlangen (DE); Ebersberger, Frank, 90518 Hilpoltstein (DE); Steger, Jürgen, 91355 Hilpoltstein (DE); Lederer, Marco, 90453 Nürnberg (DE)

(56) Entgegenhaltungen:
- EP-A- 1 376 696
- WO-A-01/33632
- DE-C1- 10 237 561

## Beschreibung

Die Erfindung beschreibt ein Leistungshalbleitermodul bestehend aus einem Gehäuse vorzugsweise mit einer Grundplatte zur Montage auf einem Kühlkörper und mindestens einem darin angeordneten elektrisch isolierenden Substrat. Dieses besteht seinerseits aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weist das Leistungshalbleitermodul Anschlusselemente für externe Last- und Hilfskontakte und auch Verbindungselemente für Verbindungen im Inneren des Leistungshalbleitermoduls auf.

Leistungshalbleitermodule, die Ausgangspunkt dieser Erfindung sind, sind beispielhaft bekannt aus der DE 103 16 356 A1 und DE 103 33 329 A1. Diese Druckschriften offenbaren jeweils Leistungshalbleitermodule in Form einer Halbbrückenschaltungsanordnung mit einem ersten und einem zweiten Leistungsschalter. Jeder dieser Leistungsschalter ist ausgebildet als eine Parallelschaltung von Leistungstransistoren mit jeweils einer zugeordneten Freilaufdiode. Je ein erster und ein zweiter Leistungstransistor mit zugeordneter Leistungsdiode ist hierbei auf einem eigenen Substrat angeordnet. Die Substrate sind gleichartig ausgebildet, weisen also einen grundsätzlich identischen Verlauf der Leiterbahnen auf. Die Unterschiede liegen ausschließlich in Hilfsverbindungsbahnen, beispielhaft für Sensoren, die nicht auf jedem Substrat vorgesehen sind.

Gemäß den als Stand der Technik genannten Druckschriften sind die Substrate derartiger Leistungshalbleitermodule ausgebildet als isolierende Substrate bestehend aus einem isolierstoffkörper ais Trägermaterial und zur elektrischen isolierung zu einer Grundplatte oder zu einem Kühlkörper. Dieser Isolierstoffkörper besteht nach dem Stand der Technik aus einer Industriekeramik beispielhaft Aluminiumoxid oder Aluminiumnitrit. Auf diesem Isolierstoffkörper auf dessen dem Inneren des Leistungshalbleitermoduls zugewandten ersten Hauptfläche befindet sich eine Mehrzahl von gegeneinander elektrisch isolierten metallischen Verbindungsbahnen. Auf diesen wiederum sind die Leistungshalbleiterbauelemente angeordnet.

Meist weist der Isolierstoffkörper auf seiner dem Inneren des Leistungshalbleitermoduls abgewandten zweiten Hauptfläche ebenfalls eine metallische Schicht gleichen Materials und gleicher Dicke wie diejenige der Verbindungsbahnen auf der ersten Hauptfläche auf. In der Regel ist diese Schicht allerdings nicht in sich strukturiert, da sie beispielhaft der Lötverbindung zu einer Grundplatte dient. Die Verbindungsbahnen sowie die metallische Schicht der zweiten Hauptfläche besteht vorzugsweise aus nach dem DCB (direct copper bonding) Verfahren aufgebrachten Kupfer, wobei das Kupfer hierbei eine typische Dicke von weniger als 1 mm aufweist.

Weiterhin weisen die genannten Leistungshalbleitermodule nach dem Stand der Technik Lastanschlusselemente auf, wobei diese jeweils im Bereich der kürzeren Außenseite des Gehäuses angeordnet sind. Diese Lastanschlusselemente für die beiden Gleichstromanschlüsse und für den Wechselstromanschluss sind als bandartiger Metallformkörper ausgestaltete. Die Lastanschlusselemente verbinden äußere Kontaktierungen mit zugeordneten Verbindungsbahnen auf dem ersten jeweils zum Lastanschlusselement benachbarten Substrat. Die Verbindungsbahnen gleicher Polarität der einzelnen Substrate untereinander sind mittels einzelner Verbindungselemente ausgebildet.

Moderne Leistungshalbleiterbauelemente, besonders Leistungstransistoren, weisen zunehmend eine höhere Stromtragfähigkeit pro Fläche auf. Somit kann bei gegebenen Abmessungen eines Leistungshalbleitermoduls dessen gesamte Leistung, die direkt mit der Stromtragfähigkeit der Leistungsschalter skaliert, gesteigert werden, durch den Einsatz von Leistungshalbleiterbauelementen gleicher Größer und höherer Stromtragfähigkeit. Da wie oben beschrieben die Verbindungsbahnen gleicher Polarität der einzelnen Substrate innerhalb des Leistungshalbleitermoduls miteinander verbunden sind, fließen der Strom für alle einzelnen Substrate bereits durch dasjenige Substrat, das mit dem Lastanschlusselement verbunden ist. Somit erweist sich als begrenzende Größe für die Leistungsfähigkeit von derartigen Leistungshalbleitermodulen die Stromtragfähigkeit der Verbindungsbahnen.

Weiterhin nachteilig an Leistungshalbleitermodulen nach dem genannten Stand der Technik ist, dass die Verbindungsbahnen positiver und negativer Polarität auf Grund der möglichst Platz sparenden Gesamtanordnung nicht direkt benachbart angeordnet sind, sondern zwischen ihnen die Wechselstromverbindungsbahn angeordnet ist. Diese Anordnung geht im Schaltbetrieb einher mit nachteiligen parasitären Induktivitäten.

Die D1 DE-C-10237561 offenbart ein Leistungshalbleitermodul mit nach außen führenden Anschlüssen und einer Mehrzahl von isolierenden Substraten mit isolierten Verbindungsbahnen und mit Leistungshalbleiterelementen, wobei sich oberhalb eines jeden Substrates mindestens ein Leitungselement befindet und mit einem Lastanschluss und einer Verbindungsbahn verbunden ist. Eine spezielle Anordnung der Polaritäten bzw. eine dahingehend spezielle Anordnung der Leitungsbahnen bezüglich der Polaritäten ist hier nicht offen gelegt.

Der Erfindung liegt die Aufgabe zugrunde ein Leistungshalbleitermodul mit einer Mehrzahl gleichartiger Substrate oder Substratabschnitte weiterzubilden, wobei die Leistungsfähigkeit bei gegebener Ausgestaltung der Substrate gesteigert wird und hierbei die Stromtragfähigkeit der Zuleitungen zu den einzelnen Substraten bei gleich bleibender Grundfläche erhöht wird und / oder die parasitären Induktivitäten im Leistungshalbleitermodul verringert werden.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einem Leistungshalbleitermodul vorzugsweise mit einer Grundplatte zur Montage auf einem Kühlkörper. Dieses Leistungshalbleitermodul weist mindestens folgende Komponenten auf: ein Gehäuse, Anschlusselemente für Last- und Hilfsanschlüsse, eine Mehrzahl von gleichartigen Substraten oder Substratabschnitten jeweils mit Verbindungsbahnen und mindestens einem Leistungshalbleiterbauelement pro Substrat oder Substratabschnitt.

Die Anschlusselemente für Lastanschlüsse führen vorzugsweise jeweils im Bereich der kürzeren Außenseite des Gehäuses aus diesem heraus und dienen der elektrischen Verbindung der im Gehäuseinneren angeordneten Leistungsschalter. Die zur Grundplatte oder einem Kühlkörper elektrisch isolierend ausgebildeten Substrate oder Substratabschnitte bestehen ihrerseits jeweils aus einem Isolierstoffkörper, vorzugsweise einer Industriekeramik, und hierauf, auf dessen der Grundplatte oder dem Kühlkörper abgewandten ersten Hauptfläche befindlich, einer Mehrzahl von gegeneinander elektrisch isolierten metallischen Verbindungsbahnen. Auf diesen Verbindungsbahnen sind Leistungshalbleiterbauelemente angeordnet und schaltungsgerecht verbunden.

Bei einer Anordnung von gleichartigen Substraten oder Substratabschnitten in Reihe und bei hierauf angeordneten Verbindungsbahnen, die entlang der Längsachse der Reihenanordnung vorgesehen sind ist es bevorzugt, wenn die Verbindungsbahnen der positiven und der negativen Polarität bei aufeinander folgenden Substraten oder Substratabschnitten alternierend angeordnet sind und mindestens zwei Leitungselemente die Verbindungsbahnen gleicher Polarität der Substrate oder Substratabschnitte verbinden.

Der erfinderische Gedanke wird anhand der Ausführungsbeispiele der Fig. 1 bis 6 näher erläutert.

Fig. 1- 5 zeigen Leistungshalbleitermodule nach dem Stand der Technik.

Fig. 6 zeigt eine Ausgestaltung eines erfindungsgemäßen Leistungshalbleitermoduls.

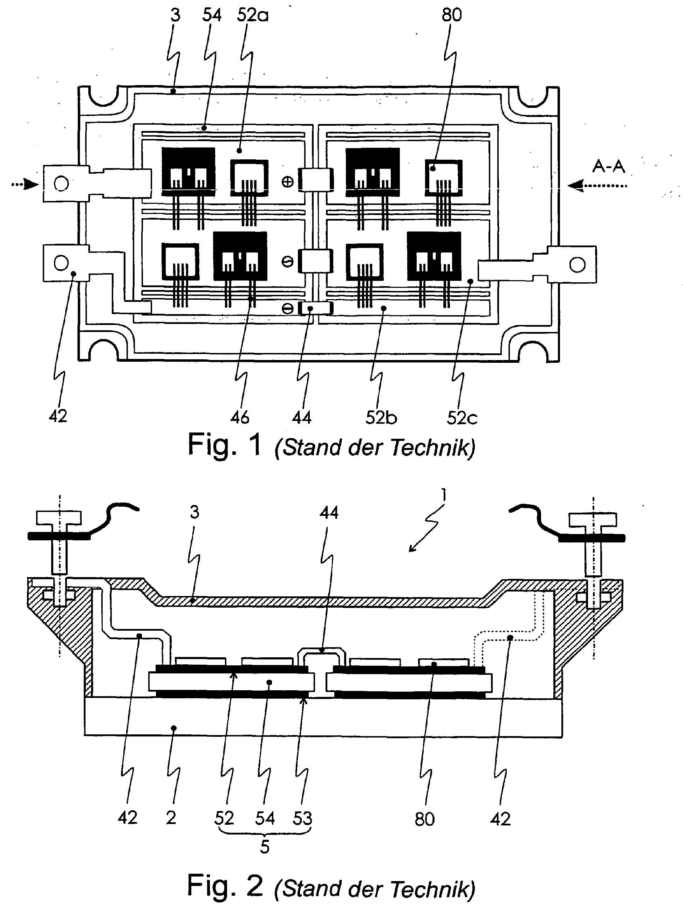

Fig. 1 und 2 zeigen ein Leistungshalbleitermodul (1) in Halbbrückenschaltungsanordnung nach dem Stand der Technik wie es Ausgangspunkt der Erfindung ist. Fig. 1 zeigt die Draufsicht und Fig. 2 einen Längsschnitt entlang der Linie A-A der Fig. 1. Das Leistungshalbleitermodul (1) weist eine Grundplatte (2) auf, worauf das das rahmenartige Gehäuse (3) sowie zwei Substrate (5) angeordnet sind. Jedes Substrat (5) besteht aus einem Isolierstoffkörper (54) sowie aus metallischen Kaschierungen, die auf beiden Hauptflächen angeordnet sind. Die der Grundplatte (2) zugewandte metallische Kaschierung (53) ist flächig ausgebildet und nicht strukturiert. Mittels einer Lötverbindung zwischen dieser Kaschierung (53) und der Grundplatte (2) werden diese zueinander fixiert. Demgegenüber ist die dem Leistungshalbleitermodulinneren zugewandte Kaschierung in sich strukturiert und bildet somit die Verbindungsbahnen (52 a/b/c) des Substrats (5) aus.

Auf diesen Verbindungsbahnen (52 a/c) sind die Leistungshalbleiterbauelemente (80) angeordnet. Die elektrischen Anschlusselemente bilden die Leistungs- (42) und die nicht explizit dargestellten Hilfsanschlüsse. Die schaltungsgerechte Verbindung der Leistungshalbleiterbauelemente (80) mit den Verbindungsbahnen (52 b/c) ist als Bondverbindung (46) ausgebildet.

Die Anschlusselemente (42) der Leistungsanschlüsse werden gebildet durch Metallformkörper, die an ihrem einen Ende löttechnisch mit der zugeordneten Verbindungsbahn (52 a/b/c) des direkt benachbarten Substrats (5) stumpf verbunden sind und an ihrem anderen Ende eine Ausnehmung zur Schraubverbindung aufweisen.

Jedes Substrat (5) weist je eine in Richtung der Längsachse des Leistungshalbleitermoduls (1) verlaufende Verbindungsbahn (52 a/b) für Leistungsanschlüsse positiver und negativer Polarität sowie eine Wechselstrom führende Verbindungsbahn (52 c) auf, wobei diese mittig zwischen den beiden Verbindungsbahnen (52 a/b) des Gleichstroms angeordnet ist. Dies ist vorteilhaft um möglichst groß dimensionierte Leistungshalbleiterbauelement (80) auf möglichst kleiner Grundfläche anzuordnen. Weiterhin sind Verbindungsbahnen (52) für Steuer- und Hilfsanschlüsse auf dem Substrat (5) angeordnet. Auf jedem Substrat (5) ist ein ersten und ein zweiter Leistungstransistor jeweils mit antiparallel geschalteter Freilaufdiode angeordnet. Die Mehrzahl von ersten und zweiten Leistungstransistoren in Parallelschaltung auf einer Mehrzahl von Substraten (5) bildet somit die beiden Leistungsschalter der Halbbrückenschaltung aus. Hierzu sind die Verbindungsbahnen (54) der Leistungsanschlüsse mittels Lötverbindern (44) miteinander elektrisch leitend verbunden.

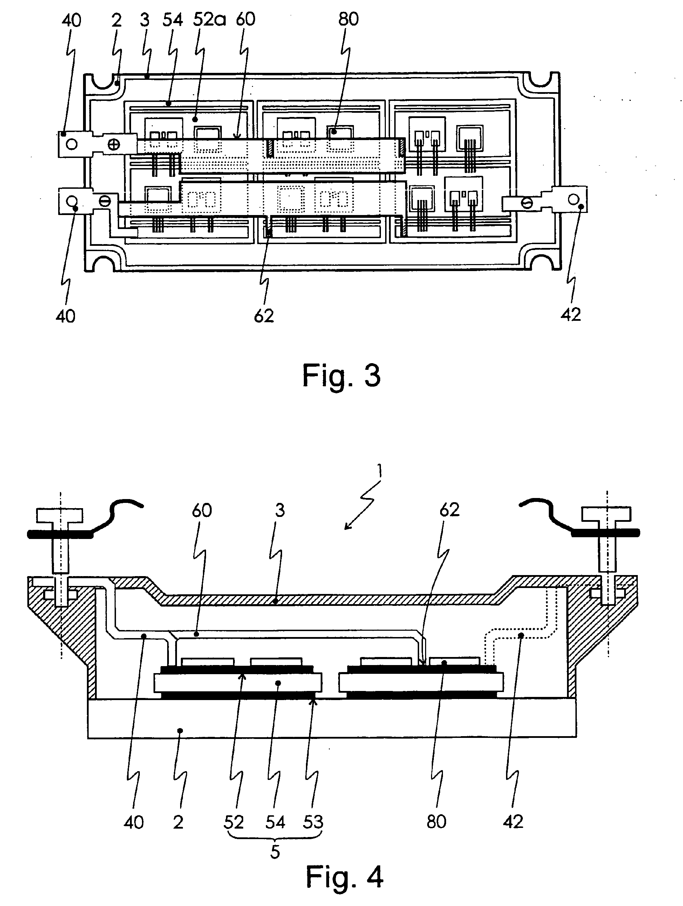

Fig. 3 und 4 zeigen ein weiteres Leistungshalbleitermodul (1) nach dem Stand der Technik. Hierbei sind die Lötverbinder (44), gemäß Fig. 1 oder 2, der Gleichstromverbindungsbahnen ersetzt durch Leitungselemente (60). Diese Leitungselemente (60) sind oberhalb und beabstandet von den Substraten (5) angeordnet. Die Lötverbinder der Verbindungsbahnen (52 c) des Wechselstroms entsprechen hierbei weiterhin dem Stand der Technik, könnten allerdings ebenso durch ein drittes Verbindungselement ersetzt werden.

Fig. 3 zeigt den Verlauf zweier Leitungselemente (60), je eines für die beiden Gleichstromanschlüsse des Leistungshalbleitermoduls (1), wobei diese Leitungselemente (60) hierbei ausgebildet sind als je ein Metallformteil analog den Leistungsanschlusselementen (40, 42). Mit den Leistungsanschlusselementen (40) sind die Leitungselemente (60) vorzugsweise mittels einer Lötverbindung verbunden. Die Verbindung zu den Verbindungsbahnen (52 a/b) der Substrate (5) erfolgt ebenfalls mittel Lötverbindung an den Verbindungsstellen (62). Die Leitungselemente (60) übernehmen den Stromanteil für das zweite und dritte Substrat (5) und entlasten so die Verbindungsbahn (52 a/b) auf dem ersten Substrat (5) von der Führung dieser Ströme. Dies ist speziell bei der Verbindungsbahn (54) negativer Polarität vorteilhaft, weil diese keine Leistungshalbleiterbauelement (80) trägt und somit einen geringeren Querschnitt im Vergleich zu den anderen Laststrom führenden Verbindungsbahnen aufweist. Die beiden Leitungselemente (60) sind im wesentlichen Teil ihres Verlaufs eng benachbart und parallel angeordnet, wodurch die parasitären Induktivitäten des Leistungshalbleitermoduls (1) deutlich verringert werden.

In der Schnittansicht gemäß Fig. 4 ist dargestellt, dass das jeweilige Verbindungselement (60) mit dem Lastanschlusselement (40) und auch mit der zugeordneten Verbindungsbahn (52) des Substrats (5) mittels einer Lötverbindung verbunden ist. Weiterhin ist der Verlauf oberhalb der Substratebene dargestellt. Durch diesen Verlauf eines Leitungselements (60) parallel zum Substrat (5), wobei auch die jeweiligen Hauptflächen des Substrats und des Leitungselements parallel zueinander verlaufen, ist die Verwendung dieser erfinderischen Weiterbildung auch in Leistungshalbleitermodulen (1) geringer Bauhöhe einsetzbar.

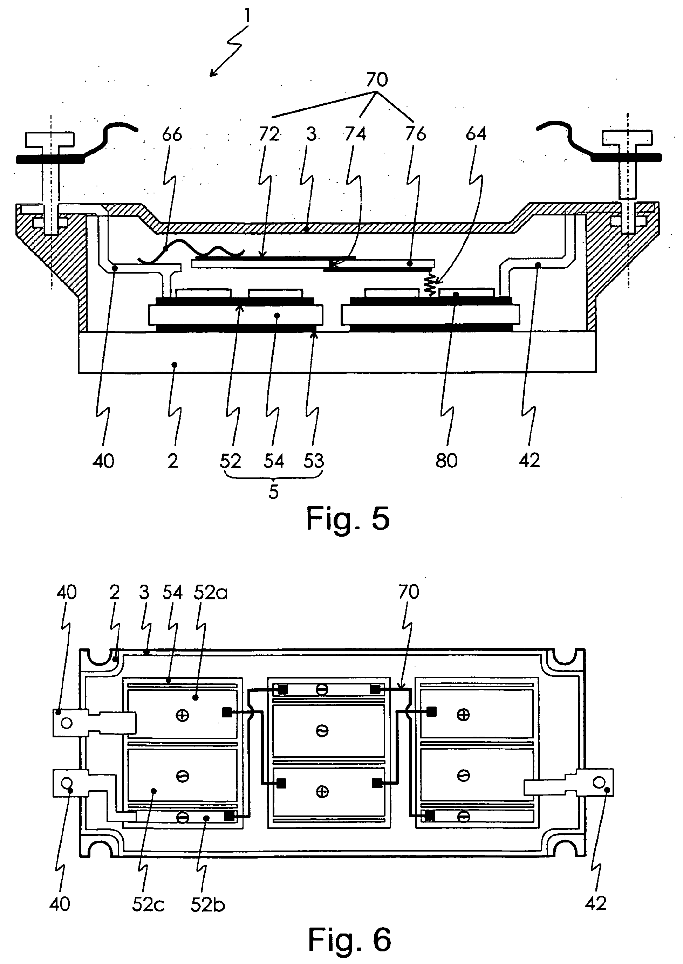

Fig. 5 zeigt eine weitere Ausgestaltung eines Leistungshalbleitermoduls (1) nach dem Stand der Technik. Hierbei ist im Vergleich zur Fig. 4 die Anbindung des Leitungselements (60) an das Lastanschlusselemente (40) sowie an die zugeordnete Verbindungsbahn (52) des Substrats (5) unterschiedlich. Für beide Verbindungen bieten sich neben der in Fig. 4 dargestellten Lötverbindung auch weitere hier dargestellte Verbindungstechniken an. Besonders bevorzugt sind hierbei Bondverbindungen (66) und / oder druckkontaktierte elastische Verbindungen mittels Federelementen (64).

Bei derartigen Verbindungen sind auch andere Ausgestaltungen des Leitungselements (70) bevorzugt. Beispielhaft ist hier die Ausgestaltung als DCB-Element geeignet. Eine derartige Verbindung mit einem Isolierstoffkörper (76) und darauf angeordneten Leitungsbahnen (72) entspricht der Technologie der Substrate (5). Hierbei sind dann für alle Polaritäten Leiterbahnen (72) mit gleichem Querschnitt vorsehbar. Ebenfalls sind bei einer derartigen Ausgestaltung auch beide Seiten des Isolierstoffkörpers (76) zur Stromleitung nutzbar. Dies erhöht einerseits die zur Stromleitung zur Verfügung stehende Querschnittsfläche und führt gleichzeitig zu einer eng benachbarten Stromführung, welche der niederinduktiven Ausgestaltung des Leistungshalbleitermoduls (1) dient.

Fig. 6 zeigt eine Ausgestaltung eines erfindungsgemäß weitergebildeten Leistungshalbleitermoduls (1). Dargestellte ist wiederum eine Halbbrückenschaltungsanordnung, wobei hier aus Gründen der Übersichtlichkeit die Leistungshalbleiterbauelemente nicht dargestellt sind. Bei dieser Ausgestaltung von drei gleichartigen Substrate (5) sind diese in Reihe angeordnet. Es kann sich hierbei um einzelne Substrate (5) oder wie auch bereits bei den vorhergehenden Ausführungsbeispielen um sog. Substratabschnitte handeln. Unter gleichartigen Substratabschnitten soll eine Analogie zu Einzelsubstraten verstanden werden, wobei einzelne Topologien von Verbindungsbahnen sich regelmäßig auf einem Isolierstoffkörper (54) wiederholen und somit eine schaltungstechnisch identische Topologie bilden, wie sie auch durch einzelne Substrate erzielbar wäre.

Wie auch gemäß Fig. 3 sind hier die einzelnen Verbindungsbahnen (52 a/b/c) entlang der Längsachse der in Reihe angeordneten Substrate (5) ausgerichtet. Im Gegensatz zu Fig. 3 alterniert hierbei allerdings die Position der Verbindungsbahnen (52 a/b) von Substrat zum benachbarten Substrat bezogen auf diese Längsachse. Somit ist auf dem ersten Substrat die Reihenfolge von oben nach unter betrachtet von positiver Polarität, Wechselstrom und negativer Polarität umgekehrt zum zweiten Substrat. Diese alternierende Anordnung wird für alle Substrate (5) beibehalten. Erfindungsgemäß sind hier schematisch dargestellte Verbindungselemente (70) angeordnet, die jeweils Verbindungsbahnen (52 a/b) gleicher Polarität der Substrate (5) oder Substratabschnitte miteinander verbinden. Hierbei müssen diese Leitungselement (70) sich in ihrem Verlauf zwischen den Kontaktpunkten auf den jeweiligen Substraten kreuzen.

Es ist weiterhin bevorzugt, wenn die Leistungselemente (70), wie oben beschrieben, mit dem jeweils zugeordneten Lastanschlusselement (40) verbunden sind. Weiterhin ist hier die Ausgestaltung der Leitungselemente (70)als Isolierstoffkörper (76) mit zweiseitigen Leiterbahnen (72), gegenüber der Ausgestaltung als Metallformkörper, besonders bevorzugt. Ebenso ist bevorzugt, dass die Ausgestaltung der Verbindungselemente als ein Substrat mit einer Mehrzahl an Leiterbahnen (72), das Überkreuzen der einzelnen Strompfade besonders vereinfacht, da hierbei Leiterbahnabschnitte beispielhaft mittels Durchkontaktierungen (74) durch den Isolierstoffkörper (76) verbunden werden und somit die Leiterbahn (72) ausbilden.

Die hier dargestellte Ausführungsform ist bezüglich der Vermeidung parasitärer Induktivitäten besonders vorteilhaft, da hier entstehende magnetische Felder von Substrat (5) zu Substrat (5) sich auf Grund der entgegen gesetzten Feldrichtung zumindest teilweise gegenseitig auslöschen.

## Patentansprüche

1. Leistungshalbleitermodul (1) mindestens bestehend aus einem Gehäuse (3), nach außen führenden Lastanschlusselementen (4), einer Mehrzahl innerhalb des Gehäuses (3) angeordneter elektrisch isolierender gleichartig ausgebildeter Substrate oder Substratabschnitte (5), wobei diese bestehen aus einem Isolierstoffkörper (54) und auf der dem inneren des Leistungshalbleitermoduls zugewandten ersten Hauptfläche befindliche einer Mehrzahl von gegeneinander elektrisch isolierten metallischen Verbindungsbahnen (52 a/b/c) unterschiedlicher Polarität, auf diesen Verbindungsbahnen angeordnet je Substrat oder Substratabschnitt mindestens ein Leistungshalbleiterbauelement (80) mit Verbindungselementen zu dessen schaltungsgerechten Verbindung,
wobei die gleichartigen Substrate (5) oder Substratabschnitte in Reihe angeordnet sind und hierauf die Verbindungsbahnen (52 a/b/c) entlang der Längsachse der Reihe angeordnet sind, wobei die Verbindungsbahnen (52 a/b) der positiven und der negativen Polarität bei aufeinander folgenden Substraten oder Substratabschnitten alternierend angeordnet sind und mindestens zwei Leitungselemente (60, 70) die Verbindungsbahnen (52 a/b/c) jeweils gleicher Polarität der Substrate oder Substratabschnitte verbinden.

2. Leistungshalbleitermodul (1) nach Anspruch 1,
wobei ein Leitungselement (60, 70) ausgebildet ist als ein Metallformteil (60) oder als ein Isolierstoffkörper (76) mit mindestens einer darauf angeordneten Leiterbahn (72).

3. Leistungshalbleitermodul (1) nach Anspruch 2,
wobei die Leitungselemente (70) ausgebildet sind als ein Isolierstoffkörper (76) mit einer Mehrzahl von Leiterbahnen (72) oder Leiterbahnabschnitten auf beiden Seiten des Isolierstoffkörpers (76) und die Leiterbahnabschnitte schaltungsgerecht miteinander verbunden sind und Leiterbahnen (72) bilden.

4. Leistungshalbleitermodul (1) nach Anspruch 3,
wobei diese Verbindungen der Leiterbahnabschnitte als Durchkontaktierungen (74) durch den Isolierstoffkörper (76) ausgebildet sind.

5. Leistungshalbleitermodul (1) nach Anspruch 1,
wobei die Verbindung zwischen der Verbindungsbahnen (52 a/b/c) des Substrats und dem zugeordneten Leitungselement (60, 70) ausgestaltet ist als eine Lötverbindung (62) oder eine Bondverbindung (66) oder mittels eines druckbeaufschlagten Federelements (64).

6. Leistungshalbleitermodul (1) nach Anspruch 1,
wobei die Verbindung zwischen dem Lastanschlusselement (40) und dem zugeordneten Leitungselement (6, 70) ausgestaltet ist als eine Lötverbindung (62)oder eine Bondverbindung (66) oder mittels eines druckbeaufschlagten Federelements (64).

7. Leistungshalbleitermodul (1) nach Anspruch 1,
wobei die Leitungselemente (60, 70) an zentraler Stelle die zugeordnete Verbindungsbahn (52) auf dem Substrat (5) oder auf dem Substratabschnitt kontaktieren.

8. Leistungshalbleitermodul (1) nach Anspruch 1,
wobei das Lastanschlusselement (40) und das Leitungselement (60) zugehöriger Polarität einstückig ausgebildet sind.

## Claims

1. A power semi-conductor module (1) comprising at least one housing (3), load connection elements (4) leading to the outside, a plurality of electrically insulating substrates or substrate sections (5) formed identically arranged within the housing (3), wherein these consist of an insulant body (54) and, located on the first main surface facing the interior of the power semi-conductor module, a plurality of metal interconnects (52 a/b/c) of different polarity electrically insulated against one another, arranged on these interconnects at least one power semiconductor component (80) per substrate or substrate section with connecting elements for the circuit-appropriate connection of said power semiconductor element, wherein the substrates (5) or substrate sections of the same type are arranged in series and on these the interconnects (52 a/b/c) are arranged in series along the longitudinal axis, wherein the interconnects (52 a/b) of the positive and the negative polarity with substrates or substrate sections following one another are arranged in an alternating manner and at least two power elements (60, 70) connect the interconnects (52 a/b/c) each of the same polarity of the substrates or substrate sections.

2. The power semiconductor module (1) according to claim 1, wherein a line element (60, 70) is designed as a shaped metal part (60) or as an insulant body (76) with at least one interconnect (72) arranged thereon.

3. The power semiconductor module (1) according to claim 2, wherein the line elements (70) are designed as an insulant body (76) with a plurality of interconnects (72) or interconnect sections on both sides of the insulant body (76) and the interconnect sections are circuit-appropriately connected with one another and form interconnects (72).

4. The power semiconductor module (1) according to claim 3, wherein these connections of the interconnect sections are designed as through-contacts (74) through the insulant body (76).

5. The power semiconductor module (1) according to claim 1, wherein the connection between the interconnects (52 a/b/c) of the substrate and the associated line element (60, 70) is configured as a soldered connection (62) or a bonded connection (66) or by means of a pressure-loaded spring element (64).

6. The power semiconductor module (1) according to claim 1, wherein the connection between the load connection element (40) and the associated line element (6, 70) is configured as a soldered connection (62) or a bonded connection (66) or by means of a pressure-loaded spring element (64).

7. The power semiconductor module (1) according to claim 1, wherein the line elements (60, 70) at a central point contact the associated interconnect (52) on the substrate (5) or on the substrate section.

8. The power semiconductor module (1) according to claim 1, wherein the load connection element (40) and the line element (60) of matching polarity are designed in one piece.

## Revendications

1. Module semi-conducteur de puissance (1) constitué d'au moins un boîtier (3), d'éléments de raccordement de charge (4) menant vers l'extérieur, d'une pluralité de substrats ou de tronçons de substrats (5) de même nature électriquement isolants disposés dans le boîtier (3), ceux-ci étant constitués d'un corps en matière isolante (54), et d'une pluralité de voies de liaison métalliques (52 a/b/c) de différentes polarités isolées électriquement les unes par rapport aux autres situées sur la première surface principale orientée vers l'intérieur du module semi-conducteur de puissance, d'au moins un composant semi-conducteur de puissance (80) par substrat ou tronçon de substrat disposé sur ces voies de liaison, avec des éléments de liaison pour sa liaison en fonction des circuits,
les substrats (5) ou tronçons de substrat de même nature étant disposés en série, et sur ces derniers les voies de liaison (52 a/b/c) étant disposées le long de l'axe longitudinal de la série, les voies de liaison (52 a/b) des polarités positive et négative étant disposées en alternance sur des substrats ou tronçons de substrats se succédant, et au moins deux éléments de ligne (60, 70) reliant les voies de liaison (52 a/b/c) de même polarité des substrats ou tronçons de substrats.

2. Module semi-conducteur de puissance (1) selon la revendication 1,
dans lequel un élément de ligne (60, 70) est réalisé sous la forme d'un élément métallique conformé (60) ou d'un corps en matière isolante (76), sur lequel est disposée au moins une voie conductrice (72).

3. Module semi-conducteur de puissance (1) selon la revendication 2,
dans lequel les éléments de ligne (70) sont réalisés sous la forme d'un corps en matière isolante (76) avec une pluralité de voies conductrices (72) ou de tronçons de voies conductrices sur les deux faces du corps en matière isolante (76), et dans lequel les tronçons de voies conductrices sont reliés entre eux en fonction des circuits et forment des voies conductrices (72).

4. Module semi-conducteur de puissance (1) selon la revendication 3,
dans lequel ces liaisons des tronçons de voies conductrices sont réalisées sous la forme de contacts transversaux (74) par le corps en matière isolante (76).

5. Module semi-conducteur de puissance (1) selon la revendication 1,
dans lequel la liaison entre les voies de liaison (52 a/b/c) du substrat et l'élément de ligne (60, 70) associé est réalisée sous la forme d'une liaison par brasage (62) ou d'une liaison par établissement de contact (66), ou au moyen d'un élément à ressort (64) sous pression.

6. Module semi-conducteur de puissance (1) selon la revendication 1,
dans lequel la liaison entre l'élément de raccordement de charge (40) et l'élément de ligne (60, 70) associé est réalisée sous la forme d'une liaison par brasage (62) ou d'une liaison par établissement de contact (66), ou au moyen d'un élément à ressort (64) sous pression.

7. Module semi-conducteur de puissance (1) selon la revendication 1,
dans lequel les éléments de ligne (60, 70) établissent le contact, au niveau d'un emplacement central, de la voie de liaison (52) associée sur le substrat (5) ou sur le tronçon de substrat.

8. Module semi-conducteur de puissance (1) selon la revendication 1,
dans lequel l'élément de raccordement de charge (40) et l'élément de ligne (60) de polarité associée sont réalisés d'un seul tenant.
